Europäisches Patentamt

European Patent Office

Office européen des brevets

(19)

(11) Veröffentlichungsnummer : **0 032 174**
**B1**

(12) **EUROPÄISCHE PATENTSCHRIFT**

(45) Veröffentlichungstag der Patentschrift :
25.07.84

(51) Int. Cl.³ : **H 01 L 21/223**, H 01 L 21/31,
C 30 B 31/02

(21) Anmeldenummer : 80107034.3

(22) Anmeldetag : 14.11.80

(54) Verfahren zum Dotieren von Siliciumkörpern durch Eindiffundieren von Bor und Anwendung dieses Verfahrens zum Herstellen von Basiszonen bipolarer Transistoren.

(30) Priorität : 20.12.79 DE 2951292

(43) Veröffentlichungstag der Anmeldung :
22.07.81 Patentblatt 81/29

(45) Bekanntmachung des Hinweises auf die Patenterteilung : 25.07.84 Patentblatt 84/30

(84) Benannte Vertragsstaaten :
DE FR GB IT

(56) Entgegenhaltungen :
FR-A- 2 374 396
GB-A- 1 195 944
US-A- 2 847 287
US-A- 3 669 775
US-A- 4 149 915
IBM TECHNICAL DISCLOSURE BULLETIN, Band 9,
Heft 9, Februar 1967, NEW YORK (US) L.H. KAPLAN:
"Protection of aluminum from HF etch by addition of
permanganate", Seite 1226
JOURNAL OF THE ELECTROCHEMICAL SOCIETY,
Band 120, Heft 10, Oktober 1973, NEW YORK (US) L.R.
PLAUGER: "Etching studies of diffusion source boron
glass", Seiten 1428-1430

(73) Patentinhaber : **IBM DEUTSCHLAND GMBH**
**Pascalstrasse 100**
**D-7000 Stuttgart 80 (DE)**
**DE**
**International Business Machines Corporation**
**Old Orchard Road**
**Armonk, N.Y. 10504 (US)**
**FR GB IT**

(72) Erfinder : **Briska, Marian**
**Nürtinger Strasse 51**
**D-7030 Böblingen (DE)**
Erfinder : **Metzger, Gert**
**Mozartstrasse 4**
**D-7036 Schönaich (DE)**
Erfinder : **Thiel, Klaus Peter**
**Reiherweg 2**
**D-7030 Böblingen (DE)**

(74) Vertreter : **Kreidler, Eva-Maria, Dr. rer. nat.**
**Schönaicher Strasse 220**
**D-7030 Böblingen (DE)**

## Beschreibung

Die Erfindung betrifft ein Verfahren zum Dotieren von Siliciumkörpern durch Eindiffundieren von Bor, bei dem in einem ersten Wärmeprozeß auf der nicht maskierten Oberfläche eines Siliciumkörpers eine Schicht aus $SiB_6$, auf dieser und auf der Oberfläche der Maske eine Schicht aus borreichem Borsilicatglas und auf dieser eine Schicht aus Borsilicatglas erzeugt werden, indem die Siliciumkörper einem eine festgelegte Bormenge enthaltenden Gasgemisch mit einem festgelegten Mengenverhältnis von Bor zu Sauerstoff eusgesetzt werden, die Borsilicatglasschichten vollständig abgelöst werden, ohne daß dabei die $SiB_6$-Schicht wesentlich angegriffen wird und in einem zweiten Wärmeprozeß mindestens ein Teil des Bors in das Silicium hineingetrieben wird. Die Erfindung betrifft auch die Anwendung dieses Verfahrens zum Herstellen von Basiszonen bipolarer Transistoren.

Zum Eindiffundieren von Bor in Silicium sind Kapseldiffusionsverfahren und Verfahren bekannt, bei welchen die Siliciumkörper einem durch das Reaktionsrohr strömenden Gasstrom, welcher eine Borquelle enthält, ausgesetzt werden. Bei der Kapseldiffusion lassen sich sehr homogene und reproduzierbare Ergebnisse erzielen. Nachteilig an der Kapseldiffusion ist jedoch, daß der Material- und apparative Aufwand sehr hoch ist. Im Vergleich zu Kapseldiffusionen sind Bordiffusionen mittels eines eine Borquelle enthaltenden Gasstromes, welcher an den Siliciumkörpern vorbeiströmt, d. h. sog. offene Diffusionen, was den apparativen Aufwand und auch das benötigte Material betrifft, wesentlich weniger aufwendig. Bei diesen offenen Diffusionen wird auf der Oberfläche des Siliciumkörpers, welcher mit Bor dotiert werden soll, ein Borsilicatglas erzeugt, indem die hocherhitzten Siliciumkörper einem oxidiertes Bor enthaltenden Gasstrom ausgesetzt werden.

Ein Verfahren dieser Art ist beispielsweise in der deutschen Offenlegungsschrift 23 16 520 beschrieben. In dem in dieser Offenlegungsschrift beschriebenen Verfahren wird während einer ersten Wärmebehandlung in inerter Atmosphäre eine Borsilicatglasschicht auf Siliciumwafer aufgebracht. Gleichzeitig werden zwischen dieser und der Siliciumoberfläche eine silicium- und borhaltige Phase ($SiB_6$) und in der Siliciumoberfläche eine dünne, mit Bor hochdotierte Schicht erzeugt. Gegen Ende der ersten Wärmebehandlung werden die Siliciumwafer eine festgelegte Zeit lang einer oxidierenden Atmosphäre ausgesetzt, während der die $SiB_6$-Phase oxidiert wird. Die Borsilicatglasschicht und die Schicht aus oxidierter $SiB_6$-Phase werden in einem Ätzmittel entfernt. Anschließend wird in einer zweiten Wärmebehandlung das Bor aus der dünnen, hochdotierten Schicht in das Silicium hineingetrieben. Das in der Offenlegungsschrift beschriebene Verfahren liefert zwar bei der Herstellung von niederdotierten Diffusionsgebieten innerhalb sehr enger Toleranzen über den Siliciumkörper und über eine ganze Charge homogene und reproduzierbare Ergebnisse, bei dem zunehmenden Trend zu dicht gepackten, hochintegrierten Schaltungen sind aber die mit dem in der Ofgenlegungsschrift beschriebenen Verfahren erzielten Ergebnisse nicht mehr voll befriedigend.

Nachteilig an dem in der Offenlegungsschrift beschriebenen Verfahren ist auch, daß sich während der Sauerstoffbehandlung nach der Belegung mit Boroxid in den dotierten Gebieten des Siliciums und vorzugsweise in den Überlappungsgebieten von mit Bor und Arsen dotierten Gebieten Kristallversetzungen ausbilden, die häufig Ursache von Kurzschlüssen bei bipolaren Transistoren sind.

Um diesen Nachteilen abzuhelfen, wurde in der deutschen Offenlegungsschrift 28 38 928 (Europäische Patentschrift 8642) ein Diffusionsverfahren zum Dotieren von Silicium mit Bor vorgeschlagen, welches zeitsparend und kostengünstig ist und sehr homogene und gut reproduzierbare Ergebnisse liefert. Bis zur Erfindung des in dieser Offenlegungsschrift beschriebenen Verfahrens glaubte man, daß zur Erzielung guter Diffusionsergebnisse die $SiB_6$-Phase vor dem Boreintreiben im zweiten Wärmeprozeß entfernt werden muß (K. M. Busen u. a. in J. Electrochem. Soc., Band 115, März 1968, Seiten 291 ff).

Bei den in der deutschen Offenlegungsschrift 28 38 928 beschriebenen Verfahren zum Dotieren von Siliciumkörpern wurde überraschenderweise festgestellt, daß auch sehr homogene und sehr gut reproduzierbare Ergebnisse innerhalb sehr enger Toleranzen, und zwar sowohl bei der Herstellung von hoch- als auch von niederohmigen Gebieten erzielt werden können, wenn vor dem zweiten Wärmeprozeß nur das Borsilicatglas vollständig abgelöst wird, ohne daß dabei die $SiB_6$-Schicht wesentlich angegriffen wird. Die Vorteile des in der zuvor genannten deutschen Offengungsschrift beschriebenen Verfahrens lassen sich besonders gut daran ablesen, daß bei seiner Anwendung zur Herstellung von Basiszonen wie auch zur Herstellung von Strukturen, welche Subisolations- neben Subkollektorbereichen aufweisen, die Anzahl der Emitter-Kollektor-Kurzschlüsse in bipolaren Transistoren wesentlich kleiner ist als bei der Herstellung von Schaltungen mit geringerer Integrationsdichte unter Anwendung zuvor bekannter Verfahren.

Nachteilig an diesem Verfahren ist jedoch, daß sich das Borsilicatglas mit verdünnter Flußsäure nicht vollständig entfernen läßt und die Siliciumplättchen zu seiner Entfernung zunächst zehn Sekunden lang in verdünnte Flußsäure, anschließend zehn Minuten lang in auf 95 °C erhitzte konzentrierte Salpetersäure und schließlich noch einmal 30 Sekunden lang in verdünnte Flußsäure getaucht werden müssen. Bei diesem Ablöseverfahren wird zwar die $SiB_6$-Phase praktisch nicht angegriffen, aber die zur Ablösung des Borsilicatglases verwendete Ätzlösung weist eine Reihe von Nachteilen auf. Beispielsweise traten durch die Verwendung von 95° heißer konzentrierter Salpetersäure Umwelt- und Sicherheitsprobleme auf. Die heiße Salpetersäure verdampft und wird während des Abätzverfahrens abgesaugt, wodurch nitrose Gase in die Atmosphäre gelangen. Außerdem korrodieren die verwendeten Apparaturen. Es besteht daher ein Bedürfnis, den bisher angewendeten Ätzzyklus zur vollständigen Entfernung des Borsilicatglases durch ein weniger gefährliches Verfahren zu ersetzen.

Aus der US-Patentschrift 3 669 775 ist ein Verfahren zur Entfernung von Bor- und Phosphorhaltigen Gläsern von der Oberfläche von Siliciumkörpern bekannt, bei dem diese zur Ablösung der Gläser ein- oder mehrmals in eine wässrige Lösung eines Chelatbildners, einer oxidierenden Säure, wie Schwefelsäure oder Salpetersäure, bei Temperaturen von mindestens 85 °C und abschließend wiederum in die wässrige Lösung eines Chelatbildners getaucht werden, wobei die Silicium-körper jeweils zwischen der Behandlung in den einzelnen Bädern mit entionisiertem Wasser gespült werden.

Auch bei diesem Verfahren treten durch die Verwendung heißer oxidierender Säuren die zuvor beschriebenen Umwelt- und Sicherheitsprobleme auf.

Aufgabe der Erfindung ist daher die Bereitstellung eines verbessertern Verfahrens zum Dotieren von Silicium-körpern durch Eindiffundieren von Bor, bei dem vor dem zweiten Wärmeprozeß die Borsilicatglasschicht 7 und die schwer lösliche borreiche Borsilicatglasschicht 9 vollständig entfernt werden, ohne daß die $SiB_6$-Phase 8 angegriffen wird.

Die Aufgabe der Erfindung wird gelöst durch ein Verfahren der eingangs genannten Art, das dadurch gekennzeichnet ist, daß die Siliciumkörper zum Ablösen der Borsilicatglasschicht 7 und der borreichen Borsilicatglasschicht 9 bei Zimmertemperatur in eine im Verhältnis 1 : 10 mit Wasser verdünnte Flußsäure, anschließend in eine wässrige, schwefelsaure $KMnO_4$-Lösung und gegebenenfalls erneut in eine im Verhältnis 1 : 10 mit Wasser verdünnte Flußsäure getaucht werden.

In einer vorteilhaften Ausgestaltung des erfindungsgemäßen Verfahrens werden die Siliciumkörper in eine 10 Gew.%-ige wässrige Schwefelsäure mit einem Gehalt an 1,6 g/l Kaliumpermanganat getaucht. Die Verweilzeiten der Siliciumkörper betragen in der mit Wasser verdünnten Flußsäure etwa 10 bis 30 Sekunden ; in der wässrigen, schwefelsauren $KMnO_4$-Lösung etwa 1 bis 3 Minuten und, falls eine weitere Behandlung mit verdünnter Flußsäure angewendet wird, etwa 30 bis 90 Sekunden in derselben. Wesentlich ist, daß der gesamte Ätzzyklus bei Zimmertemperatur, d. h. bei etwa 20 °C durchgeführt werden kann. Dadurch werden Umwelt- und Korrosionsprobleme vermieden. Außerdem können die Kosten für die Chemikalien um einen Faktor von 20 gesenkt werden, die Lösung kann ohne jegliche Schwierigkeiten angesetzt werden, und schließlich findet, wie anhand der Messungen von Oberflächen-Widerstandswerten festgestellt werden konnte, keine nachteilige Beeinflußung der Basisdiffusionsprofile statt.

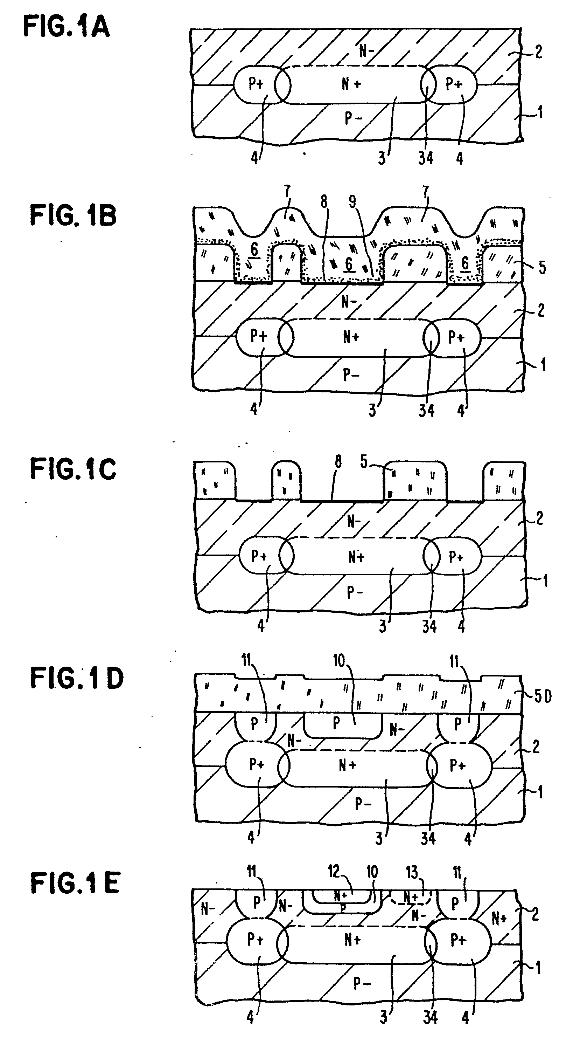

Das erfindungsgemäße Verfahren wird anhand der Herstellung einer Basiszone eines bipolaren Transistors und der Fign. 1A bis 1E beschrieben.

Die Figuren 1A bis 1E zeigen schematische Querschnittsdarstellungen von Teilen einer integrierten Schaltung (vertikaler NPN-Transistor) in verschiedenen Herstellungsphasen.

Zur Erzeugung von Basiszonen 10 bipolarer Transistoren, welche nach dem zweiten Wärmeprozeß bei Eindringtiefen im Bereich zwischen etwa 0,5 und etwa 1 μm Schichtwiderstände (RS) im Bereich zwischen etwa 300 und 700 Ohm/□ aufweisen, wird ein schwach P-dotiertes Siliciumsubstrat 1 ($5 \times 10^{15}$ Boratome/cm³) angewendet. In diesem werden als Subkollektoren 3 stark N-dotierte Bereiche ($10^{20}$ Arsenatome/cm³) ausgebildet. Nach Ablösen der hierzu verwendeten Siliciumdioxidmaske wird auf die Substratoberfläche 1 ganzflächig eine Epitaxieschicht 2 aufgewachsen. Diese ist schwach N-dotiert und enthält etwa $2 \times 10^{16}$ Arsenatome/cm³. Während des Aufwachsens der Epitaxieschicht findet, wie im einzelnen noch im Ausführungsbeispiel beschrieben wird, eine Ausdiffusion der Arsenatome und ein Einbau derselben in die über dem Subkollektor 3 gelegenen Bereiche der Epitaxieschicht 2 statt. Zur Herstellung der Basiszone 10 eines bipolaren Transistors, die die wesentlichste Anwendung des erfindungsgemäßen Verfahrens darstellt, wird auf die Epitaxieschicht 2 eine etwa 380 nm dicke Siliciumdioxidschicht 5 aufgewachsen und in derselben mittels konventioneller Methoden der Photolithographie die gewünschten Maskenöffnungen 6 erzeugt. In einem ersten Wärmeprozeß, bei dem bei einer Temperatur im Bereich zwischen etwa 850 und 950 °C gearbeitet wird, werden die Siliciumwafer nach Erreichen der Belegungstemperatur einer Bor- und Sauerstoff haltigen Gasatmosphäre ausgesetzt. Hierzu wird Argon, welches $BBr_3$ enthält und in das Sauerstoff eingeleitet wird, über die Wafer geführt. Das $O_2 : BBr_3$-Molverhältnis in dem Reaktionsgas liegt im Bereich zwischen etwa 20 und 65, und die Gesamtstrommenge liegt bei ungefähr 3,5 l/Min mit einem Zusatz von etwa 15 bis 30 mg $BBr_3$/Min, für den Fall, daß der zweite Wärmeprozeß in einer oxidierenden Atmosphäre durchgeführt wird. Unter diesen Bedingungen bildet sich auf der freiliegenden Waferoberfläche eine Schicht 8 aus $SiB_6$-Phase aus und über der gesamten Oberfläche, einschließlich der Maskenoberfläche eine Schicht 9 aus schwerlöslichem, borreichem Borsilicatglas. Das auf dieser abgeschiedene Borsilicatglas 7 ist bezüglich seiner Dicke und seiner Ätzbarkeit sehr homogen. Die Belegungszeit, welche genau eingehalten werden muß, richtet sich im allgemeinen nach dem angestrebten Oberflächenwiderstand, der Belegungstemperatur und danach, ob beim zweiten Wärmeprozeß eine oxidierende oder inerte Atmosphäre angewendet wird. Nach der Belegung werden die Siliciumwafer innerhalb von ungefähr 20 Minuten um 70 bis 100 °C abgekühlt und können dann aus dem Ofen genommen werden. Nach dem Abkühlen der Wafer auf Raumtemperatur wird das Borsilicatglas 7 und 9 abgelöst. Die Ätzbarkeit der Borsilicatglasschicht 7 hängt von dem $O_2 : BBr_3$-Verhältnis ; welches bei ihrer Herstellung angewendet wurde, ab. Im ersten Schritt des erfindungsgemäßen Ätzzyklus läßt man etwa 10 bis 30 Sekunden lang eine 1 : 10 mit Wasser verdünnte Flußsäure auf die Wafer einwirken. Während dieser Zeit wird die zuletzt abgeschiedene Borsilicatglasschicht 7 abgelöst. Im nächsten Schritt des Ätzzyklus wird während 1 bis 3 Minuten durch eine 10 Gew.%-ige wässrige Schwefelsäure mit einem Gehalt an 1,6 g/l Kaliumpermanganat die schwerlösliche, borreiche Borsilicatglas-Schicht 9 von der Oberfläche der Siliciumwafer und der Siliciumdioxidmaske 5 abgelöst. Die $SiB_6$-Phase 8 in den Öffnungen 6 wird durch dieses Ätzmittel nicht angegriffen. Wesentlich ist, daß die Entfernung der schwer löslichen Borsilicatglas-Schicht 9 bei Zimmertemperatur und in einer stark verdünnten Säurelösung stattfinden kann. Wenn es gewünscht wird, kann sich an die Behandlung mit der schwefelsauren Kaliumpermanganat-Lösung noch eine Behandlung mit verdünnter Flußsäure (Verdünnung 1 : 10), die etwa 30 bis 90 Sekunden dauert, anschließen. Während des gesamten Ätzzyklus wird die Schichtdicke der Siliciumdioxidmaske 5 von etwa 380 nm auf etwa 170 nm verringert. Im Anschluß an den Ätzzyklus wird ein zweiter Wärmeprozeß in oxidierender Atmosphäre durchgeführt. Hierbei werden bei 925 °C zunächst 10 Minuten lang 1,5 Liter Sauerstoff/Min, dann 51 Minuten lang Wasserdampf und schließlich noch einmal 10 Minuten lang 1,5 Liter Sauerstoff/Min über die mit der Siliciumdioxidmaske bedeckte Waferoberfläche geleitet. Während dieses Wärmeprozesses wird das Bor aus der Schicht 8 ($SiB_6$-Phase) in die Epitaxie 2 eingetrieben und die Basiszone 10 gebildet. Gleichzeitig wächst über der Siliciumdioxidmaske 5 thermisch weiteres Siliciumdioxid auf, wobei über der Diffusionsmaske eine Gesamtschichtdicke von etwa 300 nm und über der P-dotierten Basiszone 10 eine Schichtdicke von etwa 200 nm erhalten wird.

Nach dem Verfahren gemäß der deutschen Offenlegungsschrift 28 38 928, das durch die vorliegende Erfindung weiterentwickelt wurde, können bei Herstellung niederdotierter Gebiete, wie z. B. der Basiszonen bipolarer Transistoren, wesentlich homogenere und reproduzierbarere Ergebnisse erhalten werden als bei Verfahren gemäß dem Stand der Technik. Die Basisweite bipolarer Transistoren kann, wegen der besseren Kontrolle, kleiner gemacht werden als bei Anwendung bisher bekannter Verfahren, d. h. es können dichter gepackte, höher integrierte und wesentlich zuverlässigere Schaltungen hergestellt werden. Zur Fertigstellung des bipolaren Transistors werden im Anschluß an die Basisdiffusion noch in bekannter Weise stark N-dotierte Bereiche 12 und 13 erzeugt, wobei der Bereich 12 als Emitter des bipolaren Transistors und der Bereich 13 zur Erleichterung des Kollektoranschlusses an der Siliciumoberfläche dient. Die fertige Struktur ist mit einer Siliciumdioxidschicht bedeckt, in der sich Anschlußöffnungen zu den Bereichen 10, 11, 12 und 13 befinden.

Im Ausführungsbeispiel zeigt Fig. 1A ein schwach P-dotiertes Substrat 1. Mittels konventioneller Verfahrensschritte (Maskierung, Dotierung) wurde in dem Siliciumsubstrat 1 die vergrabene $N^+$-Schicht 3 (Subkollektor) gebildet. Mit dem Verfahren, das in der deutschen Offenlegungsschrift 28 38 928, Seite 14ff und Seite 27 unten ff, beschrieben ist, können die stark P-dotierten Bereiche 4 gebildet werden. Nach dem Ablösen der Maskenschicht wird auf dem Substrat 1 ganzflächig die N-Epitaxieschicht 2 aufgewachsen. Während des Aufwachsens der Epitaxieschicht 2 werden die Arsenatome und die Boratome auf dem Wege der Ausdiffusion aus den Bereichen 3 und 4 teilweise in den darüber gelegenen Bereichen der Epitaxieschicht 2 eingebaut. In Fig. 1A sind auch die Überlappungsgebiete 3,4 zwischen dem mit Arsen stark N-dotierten Bereich 3 und dem mit Bor stark P-dotierten Bereichen 4 zu sehen.

Auf der Struktur gemäß Fig. 1A wird in bekannter Weise, beispielsweise mittels thermischer Oxidation eine Siliciumdioxidschicht 5 erzeugt, in der durch Ätzen unter Anwendung einer Photoresistmaske in den Bereichen oberhalb des Subkollektors 3 und der stark P-dotierten Bereiche 4 Öffnungen 6 erzeugt werden. Auf der teilweise maskierten Oberfläche dieser Struktur (Fig. 1B) wird nunmehr eine die gesamte Oberfläche bedeckende Schicht (8, 9, 7) erzeugt, die aus Borsilicatgläsern unterschiedlicher Zusammensetzung aufgebaut ist. Hierzu wird gemäß der deutschen Offenlegungsschrift 28 38 928 (Seite 12, zweiter Absatz ff und Seite 25 Ende ff) über die zu bedeckende Oberfläche der Siliciumkörper in einem ersten Wärmeprozeß bei Temperaturen zwischen etwa 850 und 950 °C ein Gemisch geleitet, das Argon als Trägergas, $BBr_3$ und Sauerstoff enthält. Wie bereits ausgeführt, ist bei diesem Schritt entscheidend, welche BBr-Menge gewählt und welches $O_2 : BBr_3$-Verhältnis eingestellt wird. Das Molverhältnis $O_2 : BBr_3$ soll gemäß der deutschen Offenlegungsschrift 28 38 928 vorteilhafterweise zwischen etwa 20 und 65 liegen, wobei die Reproduzierbarkeit der Diffusionsergebnisse und die Homogenität des Borsilicatglases hinsichtlich seiner Ätzbarkeit durch einen relativ niedrigen Sauerstoffgehalt verbessert werden. Während dieses ersten Wärmeprozesses bildet sich zunächst auf der in den Öffnungen 6 freigelegten Oberfläche der Epitaxieschicht 2 eine dünne Schicht 8 aus einer siliciumreichen Borphase ($SiB_6$) und über dieser

und auf der gesamten Oberfläche der Siliciumdioxidmaske 5 eine dünne Schicht 9 aus borreichem Borsilicatglas. Anschließend wird eine Schicht 7 aus Borsilicatglas abgeschieden, deren Schichtdicke bei gegebener Temperatur von der Behandlungszeit der Siliciumkörper und der Konzentration der reaktiven Bestandteile des Gasgemisches abhängig ist.

Nach der Bordiffusion und dem Abkühlen der Siliciumkörper werden in einem zweiten Verfahrensschritt die Borsilicatglasschichten 7 und 9 vollständig entfernt. Die $SiB_6$-Schicht wird durch den nachfolgend beschriebenen Ätzzyklus nicht engegriffen. Bei diesem Ätzzyklus setzt das Verfahren gemäß dem kennzeichnenden Teil des Patentanspruchs 1 der vorliegenden Patentanmeldung ein. Zunächst wird das zuletzt abgeschiedene Borsilicatglas 7 in verdünnter Flußsäure (Verhältnis 1 : 10) abgelöst. Hierzu sind etwa 10 bis 30 Sekunden erforderlich. Die borreiche Borsilicatglasschicht 9, die die Oberflächen der Epitaxieschicht 2 und der Siliciumdioxidmaske 5-bedeckt, wird von der verdünnten Flußsäure nicht angegriffen. Diese wird aber durch das nachfolgend angegebene Ätzmittel vollständig entfernt. Man läßt eine 10 Gew.%ige wässrige Schwefelsäure mit einem Gehalt an etwa 1,6 g/l $KMnO_4$ bei Zimmertemperatur etwa 1 bis 3 Minuten lang auf die borreiche Borsilicatglasschicht 9 einwirken. Während dieser Zeit wird diese vollständig entfernt. Die $SiB_6$-Schicht 8, die Siliciumdioxidstrukturen 5 und das Silicium selbst werden durch die schwefelsaure wässrige $KMnO_4$-Lösung nicht angegriffen. Im Anschluß an diese Behandlung werden die Siliciumwafer noch einmal etwa 30 bis 90 Sekunden lang in verdünnte Flußsäure (Verhältnis 1 : 10) getaucht. Dieser dritte Ätzschritt kann, um einen unnötigen Angriff des Ätzmittels auf die Siliciumdioxidstrukturen 5 zu vermeiden, auch enffallen. Die Oberflächen-Widerstandswerte, welche in den bordotierten Bereichen gemessen wurden, wurden durch den Wegfall des dritten Ätzschritts nicht nachteilig beeinflußt. Es sei nochmals hervorgehoben, daß gemäß der Erfindung die borreiche Borsilicatglasschicht 9 mit einer gefahrlos zu handhabenden Ätzlösung anstelle der bisher verwendeten, auf 95 °C erhitzten konzentrierten Salpetersäure vollständig entfernt werden kann.

Nach dem Ablösen des Borsilicatglases (7, 9) werden die Siliciumwafer (Fig. 1C) einem zweiten Wärmeprozeß unterworfen. Dabei ist es wichtig, daß die Wafer bei der Herstellung der Basiszonen bipolarer Transistoren, d. h. niedrigdotierter Bereiche, exakt eine festgelegte Zeit lang einer oxidierenden Atmosphäre ausgesetzt werden und daß dabei die einmal festgelegte Temperatur genau eingehalten wird. Während dieses zweiten Wärmeprozesses, der gemäß der deutschen Offenlegungsschrift 28 38 928 durchgeführt wird, werden bei 925 °C über die Siliciumwafer 10 Minuten lang 1,5 Liter Sauerstoff pro Minute, dann 51 Minuten lang Wasserdampf und schließlich noch einmal 10 Minuten lang 1,5 Liter Sauerstoff pro Minute geleitet. Während dieser Behandlung wird das Bor in das Silicium eingetrieben unter Ausbildung der Bereiche 10 und 11, wobei die Bereiche 10 als Basiszonen bipolarer Transistoren und die Bereiche 11 zusammen mit den Bereichen 3 und 4 Isolationszwecken dienen. Während der Erzeugung dieser nieder mit Bor dotierten Gebiete wächst, da in oxidierender Atmosphäre gearbeitet wird, gleichzeitig eine für Maskierungszwecke verwendbare Siliciumdioxidschicht 5D auf (Fig. 1D). Außerdem wird ein wesentlicher Teil des im Silicium befindlichen Bors im Oxid gelöst, wodurch sich der Oberflächen-Widerstand stark erhöht. Anschließend werden noch in bekannter Weise stark N-dotierte Bereiche 12 und 13 erzeugt, wobei der Bereich 13 zur Erleichterung des Kollektoranschlusses und zur Verbindung zwischen der Siliciumoberfläche und dem Subkollektorbereich 3 und der Bereich 12 als Emitterbereich eines bipolaren Transistors dient. In Fig. 1E ist die fertige Struktur gezeigt. Auf dieser befindet sich (nicht dargestellt) eine Siliciumdioxidschicht mit Öffnungen für die Kontaktierung der Bereiche 10, 11, 12 und 13.

Die Anwendung des erfindungsgemäßen Verfahrens bei der beschriebenen Bordiffusion zur Herstellung der in Fig. 1E gezeigten Struktur hat verschiedene wesentliche Vorteile gegenüber der Anwendung bisher bekannter Verfahren. Durch den Ersatz der 95° heißen, konzentrierten Salpetersäure, die bisher zum Lösen der schwerlöslichen Borsilicatglasschicht 9 verwendet wurde, durch eine wässrige schwefelsaure $KMnO_4$-Lösung, die bei Zimmertemperatur anwendbar ist, werden Umweltschutzprobleme eliminiert und Sicherheitsfaktoren reduziert. Es treten keine Korrosionserscheinungen an den verwendeten Apparaturen auf. Die Kosten für die Chemikalien können um einen Faktor von etwa 20 gesenkt werden, und die Lösung kann ohne jede Schwierigkeiten angesetzt werden. Außerdem findet, wie durch Messung von Oberflächen-Widerstandswerten festgestellt werden konnte, keine nachteilige Beeinflußung der Basisdiffusionsprofile statt.

**Ansprüche**

1. Verfahren zum Dotieren von Siliciumkörpern durch Eindiffundieren von Bor, bei dem in einem ersten Wärmeprozeß auf der nicht maskierten Oberfläche eines Siliciumkörpers eine Schicht (8) aus $SiB_6$, auf dieser und auf der Oberfläche der Maske eine Schicht (9) aus borreichem Borsilicatglas und auf dieser eine Schicht (7) aus Borsilicatglas erzeugt werden, indem die Siliciumkörper einem eine festgelegte Bormenge enthaltenden Gasgemisch mit einem festgelegten Mengenverhältnis von Bor zu Sauerstoff ausgesetzt werden, die Borsilicatglasschichten (7 und 9) vollständig abgelöst werden, ohne daß dabei die $SiB_6$-Schicht 8 wesentlich angegriffen wird und in einem zweiten Wärmeprozeß mindestens ein Teil des Bors in das Silicium hineingetrieben wird, dadurch gekennzeichnet, daß die Sili-

ciumkörper zum Ablösen der Borsilicatglasschicht (7) und der borreichen Borsilicatglasschicht (9) bei Zimmertemperatur in eine im
Verhältnis 1 : 10 mit Wasser verdünnte Flußsäure,
anschließend in eine wässrige, schwefelsaure
KMnO$_4$-Lösung und gegebenenfalls erneut in
eine im Verhältnis 1 : 10 mit Wasser verdünnte
Flußsäure getaucht werden.

2. Verfahren nach Anspruch 1, dadurch gekennzeichnet, daß die Siliciumkörper zum Ablösen der borreichen Borsilicatglasschicht (9) in
eine 10 Gew.%-ige wässrige Schwefelsäure mit
einem Gehalt an 1,6 g/l Kaliumpermanganat getaucht werden.

3. Verfahren nach den Ansprüchen 1 und 2,
dadurch gekennzeichnet, daß die Siliciumkörper
etwa 10 bis 30 Sekunden lang in die im Verhältnis
1 : 10 mit Wasser verdünnte Flußsäure ; etwa 1
bis 3 Minuten lang in die Wässrige, schwefelsaure
KMnO$_4$-Lösung und gegebenenfalls etwa 30 bis
90 Sekunden lang in die im Verhältnis 1 : 10 mit
Wasser verdünnte Flußsäure getaucht werden.

4. Verfahren nach Anspruch 1, dadurch gekennzeichnet, daß das O$_2$ : Bor-Verhältnis und
die pro Zeiteinheit dem Gasgemisch zugefügte
Bormenge so festgelegt werden, daß Borsilicatglasschichten (9 und 7) entstehen, welche in
verdünnter Flußsäure nur unvollständig, durch
eine Behandlung in verdünnter Flußsäure, dann
in wässriger, schwefelsaurer KMnO$_4$-Lösung und
gegebenenfalls in verdünnter Flußsäure aber
ohne Rückstand entfernt werden.

5. Verfahren nach Anspruch 1, dadurch gekennzeichnet, daß die teilweise maskierte Oberfläche der Siliciumkörper in einem ersten
Wärmeprozeß einem Trägergasfluß ausgesetzt
wird, dem während des Belegens eine festgelegte
BBr$_3$-Menge und eine darauf abgestimmte Sauerstoffmenge zugefügt werden und daß ein
O$_2$ : BBr$_3$-Molverhältnis im Bereich zwischen
etwa 20 und 65 eingestellt wird.

6. Verfahren nach den Ansprüchen 1 und 5,
dadurch gekennzeichnet, daß beim ersten
Wärmeprozeß eine Temperatur zwischen etwa
850 und 950 °C angewendet wird.

7. Verfahren nach Anspruch 1, dadurch gekennzeichnet, daß nach dem ersten Wärmeprozeß und dem Ablösen der Borsilicatglasschichten
(7 und 9) in einem zweiten Wärmeprozeß das Bor
in oxidierender Atmosphäre in das Silicium hineingetrieben wird.

8. Verfahren nach den Ansprüchen 1 und 7,
dadurch gekennzeichnet, daß beim zweiten
Wärmeprozeß eine Temperatur von 925 °C angewendet wird.

9. Anwendung des Verfahrens nach den Ansprüchen 1 bis 8 zur Herstellung von Basiszonen
bipolarer Transistoren in hochintegrierten
Schaltungen.

**Claims**

1. Method of doping silicon bodies through the diffusion of boron, where in a first heating process on the unmasked surface of a silicon body a
layer (8) of SiB$_6$, and thereon, and on the mask
surface a layer (9) of boron-rich borosilicate
glass, and thereon a layer (7) of borosilicate glass
are generated in that the silicon bodies are
exposed to a gas mixture containing a predetermined boron quantity, with a predetermined
quantitative ratio of boron to oxygen, the borosilicate glass layers (7 and 9) are completely stripped
off without the SiB$_6$ layer (8) being substantially
affected, and in that in a second heating process
at least part of the boron is driven into the silicon,
characterized in that for the stripping off of the
borosilicate glass layer (7) and the boron-rich
borosilicate glass layer (9) the silicon bodies are
immersed at room temperature in a hydrofluoric
acid diluted with water at a ratio of 1 : 10, subsequently in an aqueous sulfuric acid KMnO$_4$ solution, and if necessary again in a hydrofluoric
acid diluted with water at a ratio of 1 : 10.

2. Method as claimed in claim 1, characterized
in that for stripping the boronrich borosilicate
glass layer (9) the silicon bodies are immersed in
an aqueous sulfuric acid of 10 % by weight containing 1.6 g/l potassium permanganate.

3. Method as claimed in claims 1 and 2, characterized in that the silicon bodies are immersed for
approximately 10 to 30 seconds in the hydrofluoric acid diluted with water at a ratio of 1 : 10,
for 1 to 3 minutes in the aqueous sulfuric acid
KMnO$_4$ solution, and if necessary for approximately 30 to 90 seconds in the hydrofluoric acid
diluted with water at a ratio of 1 : 10.

4. Method as claimed in claim 1, characterized
in that the O$_2$ : boron ratio and the boron quantity
added per time unit to the gas mixture are
determined in such a manner that borosilicate
glass layers (7, 9) are obtained which are stripped
in dilute hydrofluoric acid only incompletely, but
through a processing in dilute hydrofluoric acid,
subsequently in aqueous sulfuric acid KMnO$_4$
solution and, if necessary in dilute hydrofluoric
acid, without any residues.

5. Method as claimed in claim 1, characterized
in that the partially masked surface of the silicon
bodies is exposed in a first heating process to a
carrier gas flow to which is admixed during
coating a predetermined BBr$_3$ quantity and an
oxygen quantity adapted thereto, and that an
O$_2$ : BBr$_3$ mole ratio between approximately 20
and 65 is reached.

6. Method as claimed in claims 1 and 5, characterized in that in the first heating process a
temperature between approximately 850 and
950 °C is used.

7. Method as claimed in claim 1, characterized
in that after the first heating process and the
stripping of the borosilicate glass (7, 9) the boron
is driven into the silicon in an oxidizing atmosphere during a second heating process.

8. Method as claimed in any one of claims 1
and 7, characterized in that during the second
heating process a temperature of 950 °C is used.

9. Using the method as claimed in any one of claims 1 to 8 for making base regions of bipolar transistors in highly integrated circuits.

**Revendications**

1. Procédé de dopage de corps en silicium par diffusion de bore, où au cours d'un premier traitement thermique on fait croître une couche en SiB (8) sur la surface sans masque d'un corps en silicum et sur cette couche et sur la surface de ce masque une couche (9) en verre de borosilicate à forte teneur en bore puis sur celle-ci une couche (7) en verre de borosilicate, le corps de silicium étant exposé à un mélange chimique contenant un volume déterminé de bore avec des rapports de volume bore/oxygène déterminés, les couches en verre de borosilicate (7 et 9) sont complètement enlevées sans que la couche $SiB_6$ (8) soit attaquée de façon notable et où au cours d'un second traitement thermique au moins une partie du bore est introduite dans le silicium, caractérisé en ce que les corps en silicium sont immergés à la température ambiante dans une solution d'acide fluorhydrique dissous dans de l'eau selon un rapport 1 : 10 afin d'enlever d'une part la couche en verre de borosilicate (7) et d'autre part la couche en verre de borosilicate à forte teneur en bore (9), puis immédiatement après dans une solution aqueuse d'acide sulfurique $KMnO_4$ et en ce que le cas échéant ils sont de nouveau immergés dans une solution d'acide fluorhydrique dissous dans de l'eau selon un rapport 1 : 10.

2. Procédé selon la revendication 1, caractérisé en ce que, afin d'enlever la couche en verre de borosilicate à forte teneur en bore (9), les corps en silicium sont immergés dans une solution aqueuse contenant 10 parties de volume d'acide sulfurique avec une teneur en permanganate de potassium de 1,6 g/l.

3. Procédé selon les revendications 1 et 2, caractérisé en ce que les corps en silicium sont immergés dans une solution d'acide fluorhydrique dissous dans de l'eau selon un rapport 1 : 10 pendant 10 à 30 secondes ; puis dans une solution aqueuse contenant de l'acide sulfurique $KMnO_4$ et, le cas échéant, dans ladite solution d'acide sulfurique dissous dans de l'eau selon un rapport 1:10 pendant environ 30 à 90 secondes.

4. Procédé selon la revendication 1, caractérisé en ce que le rapport 0 : bore et la quantité de bore ajoutée au mélange gazeux par unité de temps sont déterminés de telle sorte qu'on fait croître des couches en verre de borosilicate (9 et 7) qui sont enlevées de façon partielle seulement dans une solution d'acide fluorhydrique dissous, puis au cours d'un traitement dans une solution d'acide fluorhydrique dissous, puis dans une solution aqueuse contenant de l'acide sulfurique $KMnO_4$, et enfin, le cas échéant, dans une solution d'acide fluorhydrique dissous où il n'y a aucun résidu.

5. Procédé selon la revendication 1, caractérisé en ce que la surface partiellement recouverte d'un masque desdits corps en silicium, au cours d'un premier traitement thermique, est exposée à un écoulement de gaz porteur auquel on ajoute, pendant le depôt, une quantité déterminée de $BBr_3$ et une quantité d'oxygène déterminée en fonction de cette dernière, et en ce qu'on choisit un rapport molaire $O_2 : BBr_3$ compris entre environ 20 et 65.

6. Procédé selon les revendications 1 et 5, caractérisé en ce que la température appliquée dans le premier traitement thermique est comprise entre 850 et 950 °C.

7. Procédé selon la revendication 1, caractérisé en ce qu'on diffuse le bore dans ledit silicium dans une atmosphère oxydante au cours d'un second traitement thermique après un premier traitement thermique et après que les couches en verre de borosilicate (7 et 9) aient été enlevées.

8. Procédé selon les revendications 1 et 7, caractérisé en ce que la température appliquée dans le second traitement thermique est de 925 °C.

9. Mise en œuvre du procédé selon les revendications 1 à 8 pour fabriquer des zones de base de transistors bipolaires composant des circuits à haut niveau d'intégration.

**FIG.1A**

**FIG.1B**

**FIG.1C**

**FIG.1D**

**FIG.1E**